# EUROPÄISCHE PATENTSCHRIFT

(11) **EP 2 702 845 B1**
(45) Veröffentlichungstag und Bekanntmachung des Hinweises auf die Patenterteilung: **16.08.2017**
(21) Anmeldenummer: 12709796.2
(22) Anmeldetag: 13.03.2012
(51) Int. Cl.: H05K 7/20

(54) **ANORDNUNG ZUM TEMPERIEREN, INSBESONDERE KÜHLEN, VON WÄRMEERZEUGENDEN BAUELEMENTEN MIT EINER KÜHLPLATTE**
ARRANGEMENT FOR THE TEMPERATURE CONTROL, IN PARTICULAR COOLING, OF HEAT-GENERATING COMPONENTS USING A COOLING PLATE
AGENCEMENT PERMETTANT DE THERMORÉGULER DES ÉLÉMENTS PRODUISANT DE LA CHALEUR, EN PARTICULIER DE LES REFROIDIR, À L'AIDE D'UNE PLAQUE DE REFROIDISSEMENT

(30) Priorität: 28.04.2011 DE 102011018992
(43) Veröffentlichungstag der Anmeldung: 05.03.2014
(73) Patentinhaber: Sew-Eurodrive GmbH & Co. KG, 76646 Bruchsal (DE)
(72) Erfinder: KOKER, Torsten, 76297 Stutensee (DE); SCHÜTTERLE, Ingo, 72488 Sigmaringen (DE); TRITSCHLER, Daniel, 76646 Bruchsal (DE)
(86) Internationale Anmeldenummer: PCT/EP2012/001115
(87) Internationale Veröffentlichungsnummer: WO 2012/146335

(56) Entgegenhaltungen:
- EP-A1- 1 047 294
- EP-A1- 1 047 294
- WO-A1-2009/136277
- WO-A1-2009/136277
- DE-A1- 10 203 239
- US-A1- 2008 315 736
- US-A1- 2008 315 736

## Beschreibung

Die Erfindung betrifft eine Anordnung zum Temperieren, insbesondere Kühlen, von wärmeerzeugenden Bauelementen mit einer Kühlplatte.

Es ist allgemein bekannt, wärmeerzeugende Bauelemente thermisch mit einem Kühlkörper zu verbinden der Kühlrippen aufweist.

**Aus der** US 2008/315736A1 **ist eine Kühlstruktur für ein Umrichtergehäuse bekannt.**

**Aus der** WO 2009/136277 A1 **eine Kühlplatte für einen Frequenzumrichter bekannt.**

**Aus der** EP 1 047 294 A1 **ist ein isoliertes metallisches Substrat bekannt, das durch ein zirkulierendes Kühlmittel gekühlt wird.**

**Aus der** DE 102 03 239 A1 **ist ein Kühlbaustein bekannt.**

Der Erfindung liegt daher die Aufgabe zugrunde, eine Anordnung zum Temperieren, insbesondere Kühlen, von wärmeerzeugenden Bauelementen mit einer Kühlplatte weiterzubilden, wobei die Entwärmung verbessert werden soll.

Erfindungsgemäß wird die Aufgabe bei der Anordnung zum Temperieren, insbesondere Kühlen, von wärmeerzeugenden Bauelementen mit einer Kühlplatte nach den in Anspruch 1 angegebenen Merkmalen gelöst.

Wichtige Merkmale der Erfindung bei der Anordnung zum Temperieren, insbesondere Kühlen, von wärmeerzeugenden Bauelementen mit einer Kühlplatte sind, dass die Anordnung zum Temperieren, insbesondere Kühlen, von wärmeerzeugenden Bauelementen mit einer Kühlplatte, die mit den wärmeerzeugenden Bauelementen thermisch verbunden ist,
wobei die Kühlplatte Kühlkanäle aufweist, die von einem Kühlmedium durchströmbar sind, insbesondere wobei der Wärmeübergangswiderstand von den wärmeerzeugenden Bauelementen über die Kühlplatte zum die Kühlkanäle durchströmenden Kühlmedium geringer ist als auf jedem andere Wärmeleitpfad von den wärmeerzeugenden Bauelementen zum die Kühlkanäle durchströmenden Kühlmedium,
wobei das Kühlmedium durch einen ersten Kühlkanal in einer ersten Richtung geleitet wird und darauf durch einen zweiten Kühlkanal in entgegengesetzter Richtung und darauf in einem dritten Kühlkanal in der ersten Richtung geleitet wird.

Von Vorteil ist dabei, dass durch die mäandrierende Durchströmung der Kühlplatte eine besonders effektive Entwärmung erreichbar ist. Außerdem ist ein möglichst gleichmäßiges Kühlen ermöglicht. Infolge des leistungsfähigen Kühlens ist die Kühlplatte sehr dünnwandig ausführbar, so dass die Wandstärke kleiner als die Summe der Durchmesser der übereinander, also in Richtung der Normalenrichtung der Montagefläche der Bauelemente auf der Kühlplatte, angeordneten Kühlkanäle wählbar ist.

Wichtige Merkmale der Erfindung bei der Anordnung zum Temperieren, insbesondere Kühlen, von wärmeerzeugenden Bauelementen mit einer Kühlplatte, die mit den wärmeerzeugenden Bauelementen thermisch verbunden ist, sind, dass die Kühlplatte Kühlkanäle aufweist, die von einem Kühlmedium durchströmbar sind,
insbesondere wobei der Wärmeübergangswiderstand von den wärmeerzeugenden Bauelementen über die Kühlplatte zum die Kühlkanäle durchströmenden Kühlmedium geringer ist als auf jedem andere Wärmeleitpfad von den wärmeerzeugenden Bauelementen zum die Kühlkanäle durchströmenden Kühlmedium,
wobei die Kühlplatte drei oder mehr Lagen von Kühlkanälen aufweist, wobei die Kühlkanäle jeder Lage jeweils parallel zueinander ausgerichtet sind und eine ebene Anordnung bilden, also die Mittelachsen der vorzugsweise zylindrischen Kühlkanäle in einer der jeweiligen Lage zugeordneten Ebene angeordnet sind,
das Kühlmedium durch die Kühlkanäle der ersten Lage in einer ersten Richtung geleitet wird und darauf durch die Kühlkanäle jeder nachfolgenden Lage in zur Richtung der vorherigen Lage entgegengesetzter Richtung geleitet wird.

Von Vorteil ist dabei, dass eine leistungsfähige Entwärmung erreichbar ist, indem das Kühlmedium mäandrierend durch die Kühlplatte geleitet wird. Dabei ist die Mäanderebene, also diejenige Ebene, in welcher sich der Mäander schlängelt, derart orientiert, dass die zugehörige Normalenrichtung parallel zur Kontaktfläche zwischen Kühlplatte und wärmeerzeugenden Bauelementen ausgerichtet ist, also vom Mäander nicht zu den Bauelementen hin sondern quer zur Verbindungsrichtung zwischen Mäander und Bauelement.

Bei einer vorteilhaften Ausgestaltung sind die ebenen Anordnungen parallel zueinander angeordnet, insbesondere wobei also die die Mittelachsen der Kühlkanäle enthaltenden Ebenen parallel und voneinander vorzugsweise regelmäßig beabstandet sind. Von Vorteil ist dabei, dass eine effektive leistungsfähige Entwärmung erreichbar ist.

Bei einer vorteilhaften Ausgestaltung sind die Kühlkanäle einer jeweiligen Lage voneinander regelmäßig beabstandet. Von Vorteil ist dabei, dass eine einfache Herstellung ausführbar ist. Erfindungsgemäß sind die Kühlkanäle der jeweils nachfolgenden Lage mit einem Versatz zu den Kühlkanälen der vorigen und/oder nachfolgenden Lage, angeordnet,
wobei der Versatz senkrecht zur Normalenrichtung der ebenen Anordnung, insbesondere der Ebenen, ausgerichtet ist und senkrecht zur Erstreckungsrichtung, insbesondere Mittelachse, der Kühlkanäle. Von Vorteil ist dabei, dass die Abstände der Lagen gering haltbar sind und somit die Kühlplatte sehr dünnwandig ausführbar ist. Erfindungsgemäß münden die Kühlkanäle einer Lage entweder in einem Verbindungsbereich oder in einem Umlenkbereich,
wobei der Verbindungsbereich einen Zulass oder Ablass für das Kühlmedium aufweist. Von Vorteil ist dabei, dass das abfließende oder zufließende Öl auf die Kanäle aufteilbar ist oder von diesen zusammenführbar. Erfindungsgemäß ist der Verbindungsbereich und/oder der Umlenkbereich zumindest teilweise begrenzt durch ein Deckelteil mit entsprechenden Ausnehmungen,
wobei das Deckelteil mit der Kühlplatte verbunden, insbesondere dicht und/oder stoffschlüssig verbunden ist. Von Vorteil ist dabei, dass eine einfache Herstellung ermöglicht ist, indem die Kühlplatte als Stranggussteil herstellbar ist und das Deckelteil auf seiner Innenseite entsprechende Ausnehmungen erhält, insbesondere mittels Fräsbearbeitung. Bei einer vorteilhaften Ausgestaltung weist die Kühlplatte Montageflächen beziehungsweise Kontaktflächen zur Verbindung der Kühlplatte mit den wärmeerzeugenden Bauelementen auf,
insbesondere wobei die Flächen aus der umgebenden Oberfläche der Kühlplatte hervor ragen. Von Vorteil ist dabei, dass die Kontaktflächen erhöht ausbildbar sind und somit eine einfache und klare übersichtliche Montage und außerdem eine einfache Bearbeitung, beispielsweise durch Schleifen, der Kontaktflächen beziehungsweise Montageflächen ausführbar ist, so dass eine sehr gute thermische Anbindung der Kühlplatte an das wärmeerzeugende Bauelement ausführbar ist.

Bei einer vorteilhaften Ausgestaltung durchströmt das Kühlmedium mäanderförmig die Kühlplatte, wobei die Normalenrichtung des Mäanders, insbesondere der zugehörigen Mäanderebene, parallel zur Kontaktfläche zwischen wärmeerzeugendem Bauelement und Kühlplatte ausgerichtet ist, insbesondere also der Mäander auf das Bauelement hin mäandriert oder von diesem weg. Von Vorteil ist dabei, dass eine möglichst effektive Entwärmung und gleichmäßige Temperierung erreichbar ist.

Bei einer vorteilhaften Ausgestaltung ist als Kühlmedium eine Flüssigkeit, wie Wasser, Öl oder dergleichen, oder ein Gas eingesetzt. Von Vorteil ist dabei, dass verschiedenartige Kühlmedien verwendbar sind.

Bei einer vorteilhaften Ausgestaltung wird das Kühlmedium durch einen vom Elektrogerät, insbesondere Umrichter, gespeisten Elektromotor oder Getriebemotor geführt, insbesondere durch dessen Gehäuse geführten Kühlkanäle. Von Vorteil ist dabei, dass das Kühlmedium in einem Kühlkreislauf verwendbar ist, der nicht nur das Elektrogerät sondern auch einen elektrische verbundenen Motor gegebenenfalls mit Getriebe kühlt.

Bei einer vorteilhaften Ausgestaltung sind die Normalenrichtung der Ebenen parallel zur Normalenrichtung der Montageflächen oder Kontaktflächen der wärmeerzeugenden Bauelemente auf der Kühlplatte ausgerichtet. Von Vorteil ist dabei, dass eine möglichst gleichmäßige Temperaturverteilung, also Temperierung, der Kontaktfläche zum Bauelement erreichbar ist.

Bei einer vorteilhaften Ausgestaltung weisen die Kühlplatte und/oder das Gehäuseteil Kabeldurchführungen auf. Von Vorteil ist dabei, dass Kabel in den Innenraum herausbeziehungsweise hereinführbar sind

Bei einer vorteilhaften Ausgestaltung ist an der Kühlplatte ein Gehäuseteil stoffschlüssig verbunden, insbesondere angeschweißt, das die wärmeerzeugenden Bauelemente gehäusebildend umgibt. Von Vorteil ist dabei, dass der Innenraum des Gehäuses insgesamt entwärmt wird, da die Luft des Innenraums vom Gehäuseteil und von der Kühlplatte begrenzt ist und somit auch über die Kühlplatte entwärmt wird, da das metallische Gehäuseteil mit der metallischen Kühlplatte verbunden, insbesondere schweißverbunden, ist.

Die Kühlplatte ist vorzugsweise aus Aluminium-Strangguss hergestellt.

Weitere Vorteile ergeben sich aus den Unteransprüchen. Die Erfindung ist nicht auf die Merkmalskombination der Ansprüche beschränkt. Für den Fachmann ergeben sich weitere sinnvolle Kombinationsmöglichkeiten von Ansprüchen und/oder einzelnen Anspruchsmerkmalen und/oder Merkmalen der Beschreibung und/oder der Figuren, insbesondere aus der Aufgabenstellung und/oder der sich durch Vergleich mit dem Stand der Technik stellenden Aufgabe.

Die Erfindung wird nun anhand von schematischen Abbildungen näher erläutert:
In der Figur 1 ist eine Schrägansicht auf einen Gehäuseabschnitt mit Kühlkörper eines Elektrogeräts, insbesondere Umrichter, gezeigt.

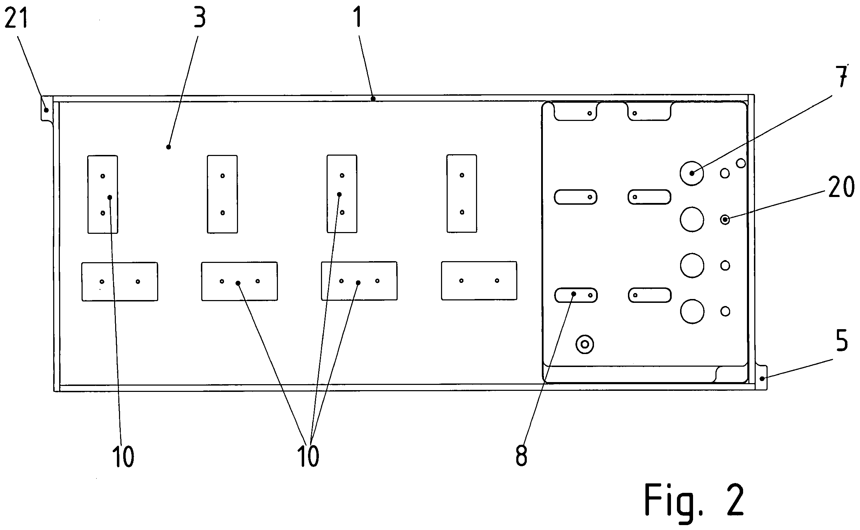

In der Figur 2 ist eine zugehörige Draufsicht gezeigt.

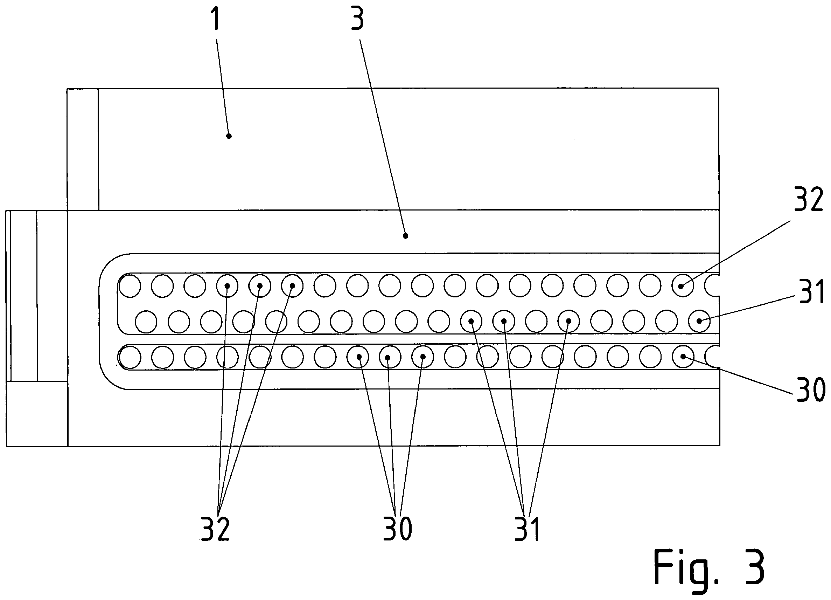

In der Figur 3 ist eine Seitenansicht mit einem Ausschnitt aus Figur 1 bei abgehobenem Deckelteil 2 gezeigt.
In der Figur 4 ist eine Schrägansicht auf einen den Ausschnitt umfassenden Bereich des Elektrogeräts gezeigt.

Dabei weist das Elektrogerät, insbesondere Umrichter, wärmeerzeugende Bauelemente, wie Leistungshalbleiterschalter, insbesondere IGBT oder MOSFET, auf, deren Wärme an Verbindungsflächen 10 an eine Kühlplatte 3 abgeführt wird. Die Verbindungsflächen sind vorzugsweise erhöht und einstückig an der Kühlplatte 3 ausgeführt.

Die Kühlplatte 3 weist an ihrer von den wärmeerzeugenden Bauelementen abgewandten Seite Kühlrippen 6 auf. Außerdem sind vorzugsweise quer zur Erstreckungsrichtung der Kühlrippen 6 in die Kühlplatte mehrere Lagen, insbesondere drei, von Kühlkanälen eingebracht.

Somit ist die Kühlplatte effektiv von einem Kühlmedium entwärmbar, welches durch die Kühlkanäle geführt wird.

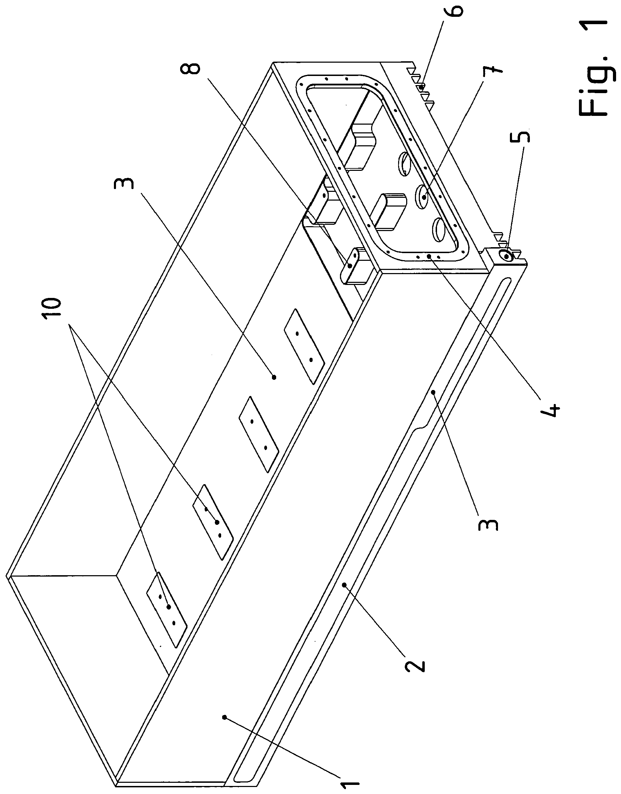

Wie in Figur 1 gezeigt, sind die wärmeerzeugenden Bauelemente von einem Gehäuseteil 1 umgeben und gehäusebildend geschützt.

Das Gehäuseteil 1 weist eine Ausnehmung auf, an deren Randberiech das Gehäuseteil 1 eine Verbindungsfläche 4 vorgesehen ist, an der ein Deckelteil aufsetzbar und dicht verbindbar ist.

Dieses Deckelteil wiederum weist Ausnehmungen als Kabeldurchführungen auf, wodurch Kabel vom Innenraum des Elektrogeräts nach außen führbar sind.

Des Weiteren weist auch die Kühlplatte 3 Ausnehmungen auf, welche als Kabeldurchführungen 7 verwendbar sind, also Kabel vom Außenbereich in den Innenraum des Elektrogeräts führen.

Die Kühlplatte weist auch weitere Befestigungsmittel 8 auf, welche zur Befestigung von weiteren Bauelementen dienen.

Seitlich sind die Mündungsöffnungen der Kühlkanäle mittels eines Deckelteils 2 abgedeckt, so dass das aus einer Anschlussvorrichtung 5 für Kühlmedium zufließende Kühlmedium, wie Wasser, Öl oder ein Gas, einem Verteilerbereich, also einem Verbindungsbereich 44 zwischen Mündungsöffnungen der Kühlkanäle der ersten Lage 30, zugeführt wird. Somit teilt sich das zugeführte Kühlmedium auf die Kühlkanäle der ersten Lage 30 auf.

An der gegenüber liegenden Seite wird das durch die erste Lage 30 von Kühlkanäle hindurchgeführte Kühlmedium umgelenkt in eine zweite Lage 31 von Kühlkanälen. Das aus diesen Kühlkanälen austretende Kühlmedium wird mittels eines Umlenkbereichs 43 für Kühlmedium zwischen zweiter Lage 31 und dritter Lage 32 umgelenkt und tritt dann durch die dritte Lage 32 von Kühlkanälen und von dort über einen Sammelraumberiech zur Anschlussvorrichtung 21 für Kühlmedium, insbesondere für Abfluss.

Das Deckelteil 2 deckt den Umlenkbereich 43 und den Verbindungsbereich 44 ab. Hierzu weist das Deckelteil 2 entsprechende durch Einfräsen gebildete Ausnehmungen auf. Das Deckelteil 2 ist mit der Kühlplatte schweißverbunden, insbesondere mittels Reibrührschweißens.

Auch das Gehäuseteil 1 ist mit der Kühlplatte 3 schweißverbunden.

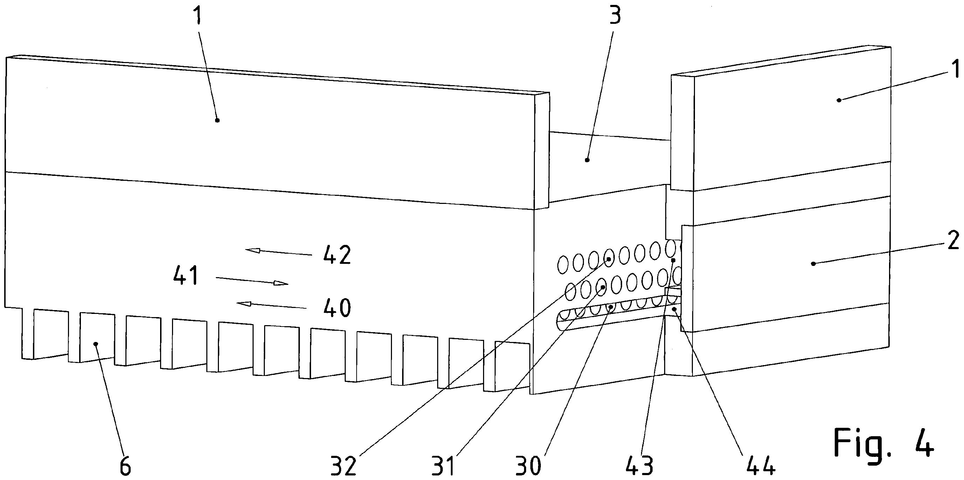

In Figur 4 ist die Flussrichtung in der ersten Lage 30 als Fließrichtung 40, die Flussrichtung in der zweiten Lage 31 als Fließrichtung 41 und die Flussrichtung in der dritten Lage 32 als Fließrichtung 42 dargestellt.

Die Kühlplatte ist also sozusagen mandelförmig durchströmt.

Die Kühlplatte 3 weist neben den Ausnehmungen 7 zur Kabeldurchführung auch noch kleinere Ausnehmungen 20 als Kabeldurchführung auf.

Die Kühlplatte ist vorzugsweise als Stranggussprofil hergestellt, wobei die Kühlkanäle gebohrt oder gefräst oder erodierend hergestellt sind.

Die Kühlkanäle der verschiedenen Lagen sind zueinander versetzt angeordnet. Somit ist eine größere Flächendichte an Kühlkanälen erreichbar. Erfindungsgemäß bilden die Mittelpunkte der Kühlkanäle also ein Dreiecksgitter. Erfindungsgemäß sind zwischen erster und zweiter beziehungsweise zwischen zweiter und dritter Lage regelmäßige Dreiecksgitter verwendet. Bei weiteren erfindungsgemäßen Ausführungsbeispielen erstrecken sich die Kühlrippen in paralleler Richtung zu den Kühlkanälen, so dass die Kühlplatte als Stranggussprofil herstellbar ist und keine Nachbearbeitung zum Herstellen der Kühlkanäle notwendig ist.

### Bezugszeichenliste

1 Gehäuseteil
2 Deckelteil
3 Kühlplatte
4 Verbindungsfläche, insbesondere Dichtfläche
5 Anschlussvorrichtung für Kühlmedium, insbesondere für Zufluss
6 Kühlrippen
7 Kabeldurchführung
8 Befestigungsmittel
10 Verbindungsfläche
20 Kabeldurchführung
21 Anschlussvorrichtung für Kühlmedium, insbesondere für Abfluss
30 erste Lage von Kühlkanälen
31 zweite Lage von Kühlkanälen
32 dritte Lage von Kühlkanälen
40 Fließrichtung in der ersten Lage 30
41 Fließrichtung in der zweiten Lage 31
42 Fließrichtung in der dritten Lage 32
43 Umlenkbereich für Kühlmedium zwischen zweiter Lage 31 und dritter Lage 32
44 Verbindungsbereich zwischen Mündungsöffnungen der Kühlkanäle der ersten Lage 30

## Patentansprüche

1. Anordnung zum Temperieren, insbesondere Kühlen, von wärmeerzeugenden Bauelementen mit einer Kühlplatte (3), die mit den wärmeerzeugenden Bauelementen thermisch verbunden ist,
wobei die Kühlplatte (3) Kühlkanäle aufweist, die von einem Kühlmedium durchströmbar sind,
insbesondere wobei der Wärmeübergangswiderstand von den wärmeerzeugenden Bauelementen über die Kühlplatte (3) zum die Kühlkanäle durchströmenden Kühlmedium geringer ist als auf jedem andere Wärmeleitpfad von den wärmeerzeugenden Bauelementen zum die Kühlkanäle durchströmenden Kühlmedium,
wobei die Kühlplatte (3) drei oder mehr Lagen (30, 31, 32) von Kühlkanälen aufweist, wobei die Kühlkanäle jeder Lage (30, 31, 32) jeweils parallel zueinander ausgerichtet sind und eine ebene Anordnung bilden, also die Mittelachsen der vorzugsweise zylindrischen Kühlkanäle in einer der jeweiligen Lage (30, 31, 32) zugeordneten Ebene angeordnet sind,
das Kühlmedium durch die Kühlkanäle der ersten Lage (30) in einer ersten Richtung geleitet wird und darauf durch die Kühlkanäle jeder nachfolgenden Lage (32) in zur Richtung der vorherigen Lage (31) entgegengesetzter Richtung geleitet wird,
wobei die Kühlkanäle der jeweils nachfolgenden Lage (32) mit einem Versatz zu den Kühlkanälen der vorigen und/oder nachfolgenden Lage (31, 32) angeordnet sind,
wobei der Versatz senkrecht zur jeweiligen Normalenrichtung der jeweils eben angeordneten Lage (30, 31, 32) ausgerichtet ist und senkrecht zur Erstreckungsrichtung, insbesondere Mittelachse, der Kühlkanäle,
wobei die Kühlkanäle einer Lage (30, 31, 32) entweder in einem Verbindungsbereich münden oder in einem Umlenkbereich,
wobei der Verbindungsbereich und/oder der Umlenkbereich zumindest teilweise begrenzt ist durch ein Deckelteil (2) mit entsprechenden Ausnehmungen,
wobei das Deckelteil (2) mit der Kühlplatte (3) verbunden, insbesondere dicht und/oder stoffschlüssig verbunden, ist,
wobei die Mittelpunkte der Kühlkanäle ein Dreiecksgitter bilden,
wobei die Mittelpunkte zwischen erster und zweiter beziehungsweise zwischen zweiter und dritter Lage (31, 32) ein regelmäßiges Dreiecksgitter bilden,
wobei der Verbindungsbereich einen Zulass oder Ablass für das Kühlmedium aufweist.

2. Anordnung nach Anspruch 1,
**dadurch gekennzeichnet, dass**
die ebenen Anordnungen parallel zueinander angeordnet sind, insbesondere wobei also die die Mittelachsen der Kühlkanäle enthaltenden Ebenen parallel und voneinander vorzugsweise regelmäßig beabstandet sind.

3. Anordnung nach mindestens einem der vorangegangenen Ansprüche,
**dadurch gekennzeichnet, dass**
die Kühlkanäle einer jeweiligen Lage (30, 31, 32) voneinander regelmäßig beabstandet sind.

4. Anordnung nach mindestens einem der vorangegangenen Ansprüche,
**dadurch gekennzeichnet, dass**
die Kühlplatte (3) Montageflächen beziehungsweise Kontaktflächen zur Verbindung der Kühlplatte (3) mit den wärmeerzeugenden Bauelementen aufweist,
insbesondere wobei die Flächen aus der umgebenden Oberfläche der Kühlplatte (3) hervor ragen.

5. Anordnung nach mindestens einem der vorangegangenen Ansprüche,
**dadurch gekennzeichnet, dass**
das Kühlmedium mäanderförmig die Kühlplatte (3) durchströmt, wobei die Normalenrichtung des Mäanders, insbesondere der zugehörigen Mäanderebene, parallel zur Kontaktfläche zwischen wärmeerzeugendem Bauelement und Kühlplatte (3) ausgerichtet ist,
insbesondere also der Mäander auf das Bauelement hin mäandriert oder von diesem weg.

6. Anordnung nach mindestens einem der vorangegangenen Ansprüche,
**dadurch gekennzeichnet, dass**
als Kühlmedium eine Flüssigkeit, wie Wasser, Öl oder dergleichen, oder ein Gas eingesetzt ist.

7. Anordnung nach mindestens einem der vorangegangenen Ansprüche,
**dadurch gekennzeichnet, dass**
die Normalenrichtung der Ebenen parallel zur Normalenrichtung der Montageflächen oder Kontaktflächen der wärmeerzeugenden Bauelemente auf der Kühlplatte (3) ausgerichtet sind.

8. Anordnung nach mindestens einem der vorangegangenen Ansprüche,
**dadurch gekennzeichnet, dass**
die Kühlplatte (3) Kabeldurchführungen (7, 20) aufweisen.

9. Elektrogerät mit einer Anordnung nach mindestens einem der vorangegangenen Ansprüche, mit einem Gehäuseteil (1) und mit wärmeerzeugenden Bauelementen, **dadurch gekennzeichnet, dass**
an der Kühlplatte (3) das Gehäuseteil (1) stoffschlüssig verbunden, insbesondere
angeschweißt ist, das die wärmeerzeugenden Bauelemente gehäusebildend umgibt.

10. System, bestehend aus einer Anordnung nach mindestens einem der vorangegangenen Ansprüche, Elektrogerät mit Gehäuseteil, Elektromotor und/oder Getriebemotor,
**dadurch gekennzeichnet, dass**
das Kühlmedium durch einen vom Elektrogerät, insbesondere Umrichter, gespeisten Elektromotor oder Getriebemotor geführt wird, insbesondere durch dessen Gehäuse geführten Kühlkanäle
und/oder
wobei die Kühlplatte (3) auf der von den wärmeerzeugenden Bauelementen des Elektrogeräts abgewandten Seite Kühlrippen (6) oder Kühlfinger aufweist.

## Claims

1. An arrangement for temperature control, in particular cooling, of heat-generating components with a cooling plate (3) which is thermally connected to the heat-generating components,
wherein the cooling plate (3) has cooling ducts through which a cooling medium can flow,
in particular wherein the heat transfer resistance from the heat-generating components via the cooling plate (3) to the cooling medium flowing through the cooling ducts is less than on any other heat-conducting path from the heat-generating components to the cooling medium flowing through the cooling ducts,
wherein the cooling plate (3) has three or more layers (30, 31, 32) of cooling ducts, wherein the cooling ducts of each layer (30, 31, 32) are in each case oriented parallel to each other and form a flat arrangement, therefore the central axes of the preferably cylindrical cooling ducts are arranged in a plane associated with the respective layer (30, 31, 32),
the cooling medium is guided through the cooling ducts of the first layer (30) in a first direction and thereupon is guided through the cooling ducts of each subsequent layer (32) in the opposite direction to the direction of the previous layer (31),
wherein the cooling ducts of the subsequent layer (32) in each case are arranged with an offset to the cooling ducts of the previous and/or subsequent layer (31, 32),
wherein the offset is oriented perpendicularly to the respective normal direction of the layer (30, 31, 32) which is arranged flat in each case and perpendicularly to the direction of extent, in particular central axis, of the cooling ducts,
wherein the cooling ducts of one layer (30, 31, 32) open either into a connection region or into a deflection region,
wherein the connection region and/or the deflection region is at least partially delimited by a cover part (2) with corresponding cutouts,
wherein the cover part (2) is connected, in particular hermetically and/or by a material-formed bond, to the cooling plate (3),
wherein the centre points of the cooling ducts form a triangular grid,
wherein the centre points between the first and second or between the second and third layer (31, 32) form a regular triangular grid,
wherein the connection region has an inlet or outlet for the cooling medium.

2. An arrangement according to Claim 1,
**characterised in that**
the flat arrangements are arranged parallel to each other, in particular with therefore the planes containing the central axes of the cooling ducts being parallel and preferably regularly spaced apart from each other.

3. An arrangement according to at least one of the preceding claims,
**characterised in that**
the cooling ducts of a respective layer (30, 31, 32) are regularly spaced apart from each other.

4. An arrangement according to at least one of the preceding claims,
**characterised in that**
the cooling plate (3) has mounting faces or contact faces for connecting the cooling plate (3) to the heat-generating components,
in particular with the faces projecting from the surrounding surface of the cooling plate (3).

5. An arrangement according to at least one of the preceding claims,
**characterised in that**
the cooling medium flows in meandering manner through the cooling plate (3), the normal direction of the meander, in particular of the associated meander plane, being oriented parallel to the contact face between the heat-generating component and cooling plate (3),
in particular therefore the meander meanders towards the component or away therefrom.

6. An arrangement according to at least one of the preceding claims,
**characterised in that**
a liquid, such as water, oil or the like, or a gas, is used as cooling medium.

7. An arrangement according to at least one of the preceding claims,
**characterised in that**
the normal direction of the planes are oriented parallel to the normal direction of the mounting faces or contact faces of the heat-generating components on the cooling plate (3).

8. An arrangement according to at least one of the preceding claims,
**characterised in that**
the cooling plate (3) have [sic] cable bushings (7, 20).

9. An electrical device with an arrangement according to at least one of the preceding claims, with a housing part (1) and with heat-generating components, **characterised in that**
the housing part (1) is connected by a material-formed bond, in particular is welded, to the cooling plate (3), which part surrounds the heat-generating components in housing-forming manner.

10. A system, consisting of an arrangement according to at least one of the preceding claims, electrical device with housing part, electric motor and/or geared motor,
**characterised in that**
the cooling medium is guided through an electric motor or geared motor supplied by the electrical device, in particular converter, in particular cooling ducts guided through the housing thereof
and/or
the cooling plate (3) having cooling ribs (6) or cooling fingers on the side remote from the heat-generating components of the electrical device.

## Revendications

1. Agencement permettant de thermoréguler, en particulier de refroidir, des éléments produisant de la chaleur à l'aide d'une plaque de refroidissement (3) qui est reliée thermiquement aux éléments produisant de la chaleur,
dans lequel la plaque de refroidissement (3) présente des canaux de refroidissement qui peuvent être parcourus par un milieu de refroidissement,
en particulier dans lequel la résistance à la transmission de chaleur sur le trajet allant des éléments produisant de la chaleur au milieu de refroidissement parcourant les canaux de refroidissement en passant par la plaque de refroidissement (3) est inférieure à celle présente sur tout autre trajet thermoconducteur allant des éléments produisant de la chaleur au milieu de refroidissement parcourant les canaux de refroidissement,
dans lequel la plaque de refroidissement (3) présente trois ou plus couches (30, 31, 32) de canaux de refroidissement, les canaux de refroidissement de chaque couche (30, 31, 32) étant orientés parallèlement les uns aux autres et formant un agencement plan, les axes médians des canaux de refroidissement de préférence cylindriques étant donc disposés dans un plan associé à la couche (30, 31, 32) respective,
dans lequel le milieu de refroidissement est conduit dans une première direction par les canaux de refroidissement de la première couche (30), puis conduit par les canaux de refroidissement de chaque couche suivante (32) dans la direction opposée à la direction de la couche précédente (31),
dans lequel les canaux de refroidissement de la couche suivante (32) respective sont disposés avec un décalage par rapport aux canaux de refroidissement de la couche précédente et/ou suivante (31, 32),
dans lequel le décalage est orienté perpendiculairement à la direction normale respective à la couche (30, 31, 32) agencée dans un plan respectif et perpendiculairement à la direction d'extension, en particulier à l'axe médian, des canaux de refroidissement,
dans lequel les canaux de refroidissement d'une couche (30, 31, 32) débouchent soit dans une zone de jonction, soit dans une zone de déviation,
dans lequel la zone de jonction et/ou la zone de déviation est limitée au moins partiellement par une partie couvercle (2) avec des évidements correspondants,
dans lequel la partie couvercle (2) est reliée à la plaque de refroidissement (3), en particulier reliée de manière étanche et/ou par liaison de matière,
dans lequel les centres des canaux de refroidissement forment un réseau triangulaire,
dans lequel les centres entre la première et la deuxième, respectivement entre la deuxième et la troisième couche (31, 32) forment un réseau triangulaire régulier,
dans lequel la zone de jonction présente une entrée ou une sortie pour le milieu de refroidissement.

2. Agencement selon la revendication 1,
**caractérisé en ce que**
les agencements plans sont disposées parallèlement les uns aux autres, en particulier dans lequel les plans contenant les axes médians des canaux de refroidissement sont donc parallèles et de préférence espacés régulièrement les uns des autres.

3. Agencement selon au moins l'une des revendications précédentes,
**caractérisé en ce que**
les canaux de refroidissement d'une couche (30, 31, 32) respective sont espacés régulièrement les uns des autres.

4. Agencement selon au moins l'une des revendications précédentes,
**caractérisé en ce que**
la plaque de refroidissement (3) présente des surfaces de montage, respectivement des surfaces de contact pour la liaison de la plaque de refroidissement (3) avec les éléments produisant de la chaleur,
en particulier dans lequel les surfaces font saillie de la surface environnante de la plaque de refroidissement (3).

5. Agencement selon au moins l'une des revendications précédentes,
**caractérisé en ce que**
le milieu de refroidissement parcourt en méandre la plaque de refroidissement (3), la direction normale au méandre, en particulier au plan de méandre associé, étant orientée parallèlement à la surface de contact entre élément produisant de la chaleur et plaque de refroidissement (3),
en particulier le méandre sinuant donc vers l'élément ou à l'opposé de celui-ci.

6. Agencement selon au moins l'une des revendications précédentes,
**caractérisé en ce**
**qu'**un liquide comme de l'eau, de l'huile ou analogue, ou un gaz est utilisé comme milieu de refroidissement.

7. Agencement selon au moins l'une des revendications précédentes,
**caractérisé en ce que**
la direction normale aux plans est orientée parallèlement à la direction normale aux surfaces de montage ou surfaces de contact des éléments produisant de la chaleur sur la plaque de refroidissement (3).

8. Agencement selon au moins l'une des revendications précédentes, **caractérisé en ce que**
la plaque de refroidissement (3) présente des traversées de câbles (7, 20).

9. Appareil électrique avec un agencement selon au moins l'une des revendications précédentes, avec une partie boîtier (1) et avec des éléments produisant de la chaleur,
**caractérisé en ce que**
la partie boîtier (1) est reliée à la plaque de refroidissement (3) par liaison de matière, en particulier soudée, et entoure les éléments produisant de la chaleur en formant un boîtier.

10. Système composé d'un agencement selon au moins l'une des revendications précédentes, d'un appareil électrique avec partie boîtier, d'un moteur électrique et/ou d'un motoréducteur,
**caractérisé en ce que**
le milieu de refroidissement est conduit à travers un moteur électrique ou un motoréducteur alimenté par l'appareil électrique, en particulier un variateur, en particulier par des canaux de refroidissement passant à travers son boîtier et/ou
dans lequel la plaque de refroidissement (3) présente des ailettes de refroidissement (6) ou des doigts de refroidissement du côté opposé aux éléments produisant de la chaleur de l'appareil électrique.
